(19) Europäisches Patentamt / European Patent Office / Office européen des brevets

(11) **EP 1 844 883 B1**

(12) **EUROPEAN PATENT SPECIFICATION**

(45) Date of publication and mention
of the grant of the patent:
**11.04.2012 Bulletin 2012/15**

(21) Application number: **06713252.2**

(22) Date of filing: **01.02.2006**

(51) Int Cl.:
*B22F 1/00* (2006.01)   *B22F 1/02* (2006.01)
*B22F 9/00* (2006.01)   *B22F 9/24* (2006.01)
*H01L 21/288* (2006.01)   *H01L 21/3205* (2006.01)

(86) International application number:
**PCT/JP2006/302109**

(87) International publication number:
**WO 2006/082996 (10.08.2006 Gazette 2006/32)**

(54) **SILVER PARTICLE POWDER AND PROCESS FOR PRODUCING THE SAME**

SILBERPARTIKELPULVER UND HERSTELLUNGSVERFAHREN DAFÜR

POUDRE DE PARTICULES D'ARGENT ET PROCÉDÉ DE PRODUCTION DE LADITE POUDRE

(84) Designated Contracting States:
**DE FR GB NL**

(30) Priority: **02.02.2005 JP 2005026866**

(43) Date of publication of application:
**17.10.2007 Bulletin 2007/42**

(73) Proprietor: **DOWA Electronics Materials Co., Ltd.
Chiyoda-ku
Tokyo 101-0021 (JP)**

(72) Inventor: **SATO, Kimitaka, c/o Dowa Electronics
Materials
Chiyoda-ku, Tokyo, 1010021 (JP)**

(74) Representative: **Wagner & Geyer
Partnerschaft
Patent- und Rechtsanwälte
Gewürzmühlstrasse 5
80538 München (DE)**

(56) References cited:
WO-A-03/032084          JP-A- 11 246 901
JP-A- 2003 226 901       JP-A- 2004 183 009
US-A1- 2002 018 896

• TETSUHI YAMAMOTO ET AL: "Microwave-assisted Preparation of Silver Nanoparticles" CHEMISTRY LETTERS, CHEMICAL SOCIETY OF JAPAN, TOKYO, JP, vol. 33, no. 2, 1 January 2004 (2004-01-01), pages 158-159, XP009117469 ISSN: 0366-7022

• AYYAPPAN S. ET AL.: 'Nanoparticles of Ag, Au, Pd and Cu produced by alcohol reduction of the salts' JOURNAL OF MATERIALS RESEARCH vol. 12, no. 2, February 1997, pages 398 - 401, XP001119328

• HAH H.J. ET AL.: 'Preparation of Sliver Nanoparticles through Alcohol Reduction with Organoalkoxysilanes' JOURNAL OF SOL-GEL SCIENCE AND TECHNOLOGY vol. 26, no. 1/3, January 2003, pages 467 - 471, XP008067312

**EP 1 844 883 B1**

## Description

Technical Field

The present invention relates to a spherical, fine, particulate powder of silver (especially one of a particle diameter on the nanometer order) and a liquid dispersion thereof, particularly to a particulate silver powder low in corrosive components that is a suitable interconnect forming material for fabricating fine circuit patterns, especially for forming interconnects by the ink-jet method, and a method of manufacturing the powder. The particulate silver powder of the present invention is also a suitable material for forming interconnects on LSI substrates, and electrodes and interconnects of flat panel displays (FPDs), and for filling in fine trenches, via holes and contact holes. It is also suitable for use as a coloring material for automobile paints and the like. Moreover, its low impurity content and toxicity level make it useful as a carrier for adsorbing biochemical substances and the like in the fields of medical treatment, diagnostics and biotechnology.

Background Art

When the size of solid substance particles reaches the ultrafine nanometer order (called "nanoparticles" in the following), the specific surface area of the particles becomes very great, so that, even though they are solids, their interface with a gas or liquid becomes extremely large. Their surface characteristics therefore strongly affect the properties of the solid substance.

It is known that the melting point of metal nanoparticles is dramatically reduced from that in the bulk state. In comparison with conventional micrometer-order particles, therefore, metal nanoparticles offer not only fine interconnect formation capability but also other features such as low-temperature sinter capability. Owing to the low resistance and excellent weatherability of silver nanoparticles, and also their low price compared with other noble metal nanoparticles, silver nanoparticles are seen as metal nanoparticles with particular promise as the next-generation material for fine interconnects.

Known methods of manufacturing nanometer-order particlesof silver are broadly divided into vapor phase methods and liquid phase methods. Vapor phase methods are ordinarily methods that conduct deposition in a gas. Patent Document 1 describes a method of vaporizing silver in a helium or other inert gas atmosphere, under a reduced pressure of around 0.5 torr. Patent Document 2 teaches a liquid phase method for obtaining a silver colloid by reducing silver ions in an aqueous phase using an amine and transferring the obtained silver deposition phase to an organic solvent phase (polymeric dispersant). Patent Document 3 describes a method in which a reducing agent (alkali metal borohydride or ammonium borohydride) is used to reduce a silver halide in a solvent in the presence of a thiol type protective agent.

Patent Document 1: JP 2001-35255A
Patent Document 2: JP 11-319538 A
Patent Document 3: JP 2003-253311A

Problems to be overcome by the Invention

The silver particles obtained by the vapor phase method of Patent Document 1 are 10 nm or less in diameter and have good dispersibility in solvent. However, the technology requires a special apparatus. This makes it difficult to synthesize large quantities of silver nanoparticles for industrial use. In contrast, the liquid phase method is basically suitable for large-volume synthesis but has a problem in that the metal nanoparticles in the liquid have a strong tendency to agglomerate, making it difficult to obtain a monodispersed nanoparticle powder. In most cases, citric acid is used as the dispersant when manufacturing metal nanoparticles, and the metal ion concentration in the liquid is usually very low as 10 mmole/L (0.01 mole/L) or lower. This is a barrier to its industrial application.

Although the foregoing method of Patent Document 2 achieves synthesis of stably dispersed silver nanoparticles by using a high metal ion concentration of 0.1 mole/L or greater and a high reaction mixture concentration, it suppresses agglomeration by using a polymeric dispersant having a high number average molecular weight of several tens of thousands. The use of a dispersant of high molecular weight is not a problem when the silver nanoparticles are to be used as a coloring material, but when the particles are to be used in circuit fabrication applications, a firing temperature that is equal to or higher than the polymer boiling point is required and, in addition, pores readily form in the interconnects after the firing, so that problems of high resistance and breakage arise, making the particles not altogether suitable for fine interconnect applications.

The foregoing method of Patent Document 3 conducts the reaction at a relatively high reactant concentration of 0.1 mole/L or greater and disperses the obtained silver particles of 10 nm or less using a dispersant. As a suitable dispersant, Patent Document 3 proposes a thiol type dispersant, which can be readily vaporized by low-temperature firing at the time of interconnect formation because it has a low molecular weight of around 200. However, the thiol type surfactant contains sulfur (S), and sulfur causes corrosion of interconnects and other electronic components, making it an unsuitable element for interconnect formation applications. The method is therefore not suitable for interconnect formation applications.

Moreover, the liquid phase method uses silver nitrate, silver halide or the like as the silver source material (Patent Documents 2 and 3), so that the reaction solution unavoidably contains many ions originating from the silver source material, such as $I^-$, $Cl^-$, $SO_4^{2-}$, $NO_3^-$ and $CN^-$. In the case of nanoparticles, specific surface area is extraordinarily large, solid-liquid separation and washing are difficult, and the reactivity of the ions with silver is high since most of the ions originating from the starting material originally formed compounds with silver. Because of these and other factors, the ions originating from the starting material are found to be adsorbed on the silver particles after reaction or to have reacted with them and become present as inclusions therein. A liquid dispersion prepared using the particles similarly contains the ions as impurities. On the other hand, the increasingly sophisticated performance capabilities of electronic equipment in recent years has placed severe demands on the components of such equipment, and the content of constituents and elements that degrade reliability is required to be managed on the ppm order. Under such circumstances, it is undesirable for corrosive components like $I^-$, $Cl^-$, $SO_4^{2-}$, $NO_3^-$ and $CN^-$ to be entrained in the liquid dispersion of the particulate silver powder.

Therefore, an object of the present invention is to overcome such problems by providing a nanoparticle powder of silver low in corrosive components that is suitable for fine interconnect formation applications, and a liquid dispersion thereof, at low cost and in large quantities. Moreover, since monodispersion of spherical silver nanoparticles of uniform diameter is preferable, another object is to provide a liquid dispersion of such silver particles.

Attention is drawn to CHEMISTRY LETTERS, CHEMICAL SOCIETY OF JAPAN, TOKYO, Vo1.33, No. 2 (2004), page 158-159, which discloses a microwave-assisted alcohol reduction of a fatty acid silver salt. Silver nano-particles resulting from the reduction, have an average particle diameter of 4-8 nm and seem to have a small standard deviation from the average particle diameter as well as an aspect ratio of less than 1.5.

Furthermore, US 2002-18896 A1 discloses a composite metallic particle in which a surface of a core metal produced from a metallic salt, a metallic oxide, or metallic hydroxide and having a particle diameter of 1 to 100 nm is covered with an organic compound including a functional group having chemisorption capacity onto the surface of said core. Especially a silver particle covered with alcoholic hydroxyl group such as stearyl alcohol is disclosed, wherein the silver particles are produced by a method of heating a ground mixture of stearyl alcohol and silver carbonate at 150° for one hour in a flask.

JP 2004-183009A discloses a method for producing a silver particle comprising transferring a silver ion from a water phase to a water-insoluble organic solvent in the presence of a phase transporting agent such as octyl-amine, dodecane-nitrile dodecanoic acid and benzoic acid and the likes, forming a colloid solution of silver fine particles by mixing the above organic solvent containing the silver ion with a reduction agent in the presence of organic protective agent, and removing the solvent from the system to thereby recover the silver particles covered by the protective agent.

Means for solving the problem

In accordance with the present invention, a method of manufacturing a particulate silver particle and method for manufacturing a liquid dispersion of silver particles as set forth in claims 1 and 2, respectively, are provided. Further embodiments of the invention are claimed in the dependent claims.

In the methods there may be used a particulate silver powder having an average particle diameter measured by TEM observation (DTEM) of 200 nm or less, preferably 100 nm or less, more preferably 30 nm or less, an aspect ratio of less than 2.50, and a $\{(DTEM) / (Dx)\}$ of 5.0 or less (where $(Dx)$ denotes X-ray crystallite size), which particulate silver powder has a content of each of $I^-$, $Cl^-$, $SO_4^{2-}$, $NO_3^-$ and $CN^-$ of 100 ppm or less. The particulate silver powder preferably has a TEM average particle diameter (DTEM) of 100 nm, preferably 30 nm or less, and has adhered to the surfaces of the particles thereof an organic protective agent (typically a fatty acid or an amine compound) having a molecular weight of 100 to 400.

The present invention further provides a liquid dispersion of silver particles obtained by dispersing such particulate silver powder in an organic solvent (typically a non-polar or low-polarity solvent), which liquid dispersion of silver particles has an average particle diameter (D50) measured by the dynamic light-scattering method of 200 nm or less, a degree of dispersion $\{(D50) / (DTEM)\}$ of 5.0 or less, and a content of each of $I^-$, $Cl^-$, $SO_4^{2-}$, $NO_3^-$ and $CN^-$ of 100 ppm or less.

Further, as a method of manufacturing such a particulate silver powder, the present invention provides a method of manufacturing a particulate silver powder, wherein a silver compound other than silver nitrate (typically silver carbonate or silver oxide) is reduced in an organic solvent (typically an alcohol or polyol) having a boiling point of 85 °C or greater at a temperature of 85 °C or greater and in the presence of an organic protective agent (typically a fatty acid or amino compound having a molecular weight of 100 to 400).

Brief Description of the Drawings

FIG 1 is an electron microscope (TEM) photograph of a nanoparticle powder of silver of the present invention.

FIG 2 is an electron microscope (TEM) photograph of the nanoparticle powder of silver of the present invention taken at a different magnification from that of FIG 1.

FIG 3 is an electron microscope (TEM) photograph of another nanoparticle powder of silver of the present invention.

FIG 4 is an electron microscope (TEM) photograph of the other nanoparticle powder of silver of the present invention taken at a different magnification from that of FIG. 3.

FIG 5 is an x-ray diffraction chart of a nanoparticle powder of silver of the present invention.

Preferred Embodiments of the Invention

The present inventor conducted numerous experiments to manufacture nanoparticle powder of silver by the liquid phase method and found it was possible to obtain a powder composed of spherical silver nanoparticles of uniform particle diameter by subjecting a silver compound other than silver nitrate (typically silver carbonate or silver oxide) to reduction treatment at a temperature of 85 °C or greater in an alcohol or polyol having a boiling point of 85 °C or greater (while refluxing vaporized alcohol or polyol to the liquid phase) and in the co-presence of an organic protective agent having a molecular weight of 100 to 400. This nanoparticle powder of silver disperses well in a dispersant because it is in a condition of having the organic protective agent adhered to its surface. Moreover, the powder can be consistently obtained with a particle diameter on the nanoparticle order of 200 nm or less, preferably 100 nm or less, more preferably 30 nm or less. In addition, the powder has a content of each of $I^-$, $Cl^-$, $SO_4^{2-}$, $NO_3^-$ and $CN^-$ of 100 ppm or less and was therefore found capable of serving as a material suitable for forming interconnects of fine circuit patterns, especially for forming interconnects by the ink-jet method.

The characteristic features of the invention particulate silver powder are explained individually below.

- TEM particle diameter (DTEM)

The average particle diameter (DTEM) of the invention particulate silver powder measured by TEM (transmission electron microscope) observation is 200 nm or less, preferably 100 nm or less, more preferably 30 nm or less. It is determined by measuring the diameters of 300 discrete, non-overlapping particles observed in a 600000x TEM image and calculating the average thereof. The aspect ratio is determined from the same observational results.

- Aspect ratio

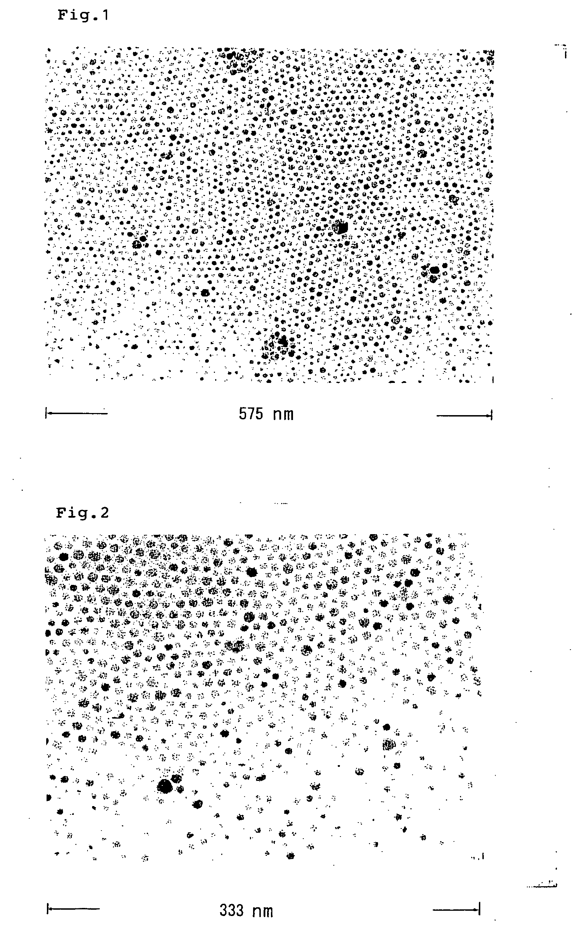

The aspect ratio (ratio of long diameter / short diameter) of the particulate silver powder of this invention is less than 2.0, preferably not greater than 1.2, more preferably not greater than 1.1. The particles in the photograph of FIG 1 are substantially spherical and have an (average) aspect ratio of not greater than 1.05. They are therefore ideal for interconnect formation applications. If the aspect ratio of not less than 2.0, particle packing is degraded when the particle liquid dispersion is applied to a substrate and dried, which may cause pores to occur during firing, increasing the resistance and possibly giving rise to interconnect breakage.

- Degree of single crystal grain

Degree of single crystal grain {(DTEM) / (Dx)} is represented by the ratio of TEM particle diameter to X-ray crystallite size. X-ray crystallite size (Dx) can be determined from the results of x-ray diffraction measurement using the Scherrer relationship. It is determined as follows.

The Scherrer relationship is expressed by the general equation:

$$D = K \cdot \lambda / \beta \, \mathrm{Cos} \, \theta,$$

where K is Scherrer constant, D is crystallite size, $\lambda$ is wavelength of the x-ray used for the measurement, $\beta$ is half-value width of the x-ray diffraction peak, and $\theta$ is Bragg angle of the diffraction line.

If 0.94 is used as the value of K and a Cu X-ray tube is used, the equation can be rewritten as:

$$D = 0.94 \times 1.5405 / \beta \, \mathrm{Cos} \, \theta.$$

Degree of single crystal grain is represented by the ratio of TEM particle diameter to X-ray crystallite size {(DTEM) / (Dx)}. The degree of single crystal grain approximately corresponds to the number of crystals per particle. The higher the value of the degree of single crystal grain, the greater is the number of crystallites, which called the particle to be composed of multiple crystals. The degree of single crystal grain of the invention silver particles is 5.0 or less, preferably 2.0 or less, more preferably 1.0 or less. Grain boundaries within the particles are therefore few. Electrical resistance rises with increasing number of grain boundaries present. In the invention particulate silver powder, the value of the degree of single crystal grain is low, which gives it low resistance and makes it suitable for use in conductors.

- Average particle diameter by the dynamic light-scattering method

The invention liquid dispersion obtained by mixing the particulate silver powder and the organic solvent has an average particle diameter (D50) by the dynamic light-scattering method of 200 nm or less and the degree of dispersion {(D50) / (DTEM)} is 5.0 or less.

The particulate silver powder of this invention readily disperses in the dispersion medium and can remain in a stable dispersed state in the dispersion medium. The dynamic light-scattering method can be used to assess the state of dispersion of the silver nanoparticles in the dispersion medium, and also to calculate the average particle diameter. The principle of the method is as follows. In a liquid, the translational, rotational and other forms of Brownian movement of particles having a diameter in the range of around 1 nm to 5 $\mu$m ordinarily changes the location and orientation of the particles from instant to instant. When a laser beam is projected onto the particles and the scattered light that emerges is detected, there are observed fluctuations in the scattered light intensity that are attributable to the Brownian movement. By measuring the time dependence of the scattered light intensity, it is possible to determine the velocity of the Brownian movement (diffusion coefficient) of the particles and also to learn the size of the particles. If the average diameter of the particles in the dispersion medium measured utilizing this principle is close to the average particle diameter obtained by TEM observation, this means that the particles in the liquid are individually dispersed (not attached to each other or agglomerated). In other words, the particles in the dispersion medium are spaced apart from each other and thus in a state that enables them to move independently.

The average particle diameter of the particulate silver powder in the invention liquid dispersion determined by carrying out the dynamic light-scattering method thereon is on a level not much different from the average particle diameter found by TEM observation. More specifically, the average particle diameter of the invention liquid dispersion measured by the dynamic light-scattering method is 200 nm or less, preferably 100 nm or less, and more preferably 30 nm or less, which is not very different from the average particle diameter by TEM observation. This means that, a monodispersed state is achieved and indicates that the present invention is capable of providing a liquid dispersion in which the nanoparticles of the silver powder are independently dispersed.

Still, even when the particles are completely monodispersed in the dispersion medium, cases arise in which measurement error or the like causes differences to arise with respect to the average particle diameter obtained by TEM observation. For example, the concentration of the liquid dispersion during the measurement must be suitable for the performance and the scattered light detection system of the measurement apparatus, and errors occur if the concentration does not ensure transmission of enough light. Moreover, the signal obtained when measuring nanometer-order particles is so feeble that contaminants and dust come to have a strong effect that may cause errors. Care is therefore necessary regarding pretreatment of samples and the cleanliness of the measurement environment. The laser beam source used for nanometer-order particle measurement should have an output power of 100 mW or greater so as to ensure adequate scattered light intensity. In addition, it is known that when the dispersion medium is adsorbed on the particles, the adsorbed dispersion medium layer has an effect that works to increase particle diameter even when the particles are completely dispersed. This effect becomes particularly manifest when particle diameter falls below 10 nm. So it can be assumed that good dispersion is maintained even if the dispersed particles do not have exactly the same degree of dispersion as the value found by the TEM observation, provided that the degree of dispersion (D50) / (DTEM) is 5.0 or less, preferably 3.0 or less.

The particulate silver powder of the present invention contains each of the ions $I^-$, $Cl^-$ $SO_4^{2-}$, $NO_3^-$ and $CN^-$ at 100 ppm or less. Therefore, so long as a high-purity dispersion medium is used, the liquid dispersion prepared by dispersing the powder in the dispersion medium can also have a content of each of the ions $I^-$, $Cl^-$, $SO_4^{2-}$, $NO_3^-$ and $CN^-$ of 100 ppm or less. Dispersion mediums suitable for use in the present invention include, for example, non-polar and low-polarity organic dispersants such as hexane, toluene, kerosene, decane, dodecane or tetradecane.

- Manufacturing method

The particulate silver powder of the present invention can be manufactured by subjecting a silver salt other than silver nitrate (typically silver carbonate or silver oxide) to reduction treatment at a temperature of 85°C or greater in an alcohol or polyol having a boiling point of 85 °C or greater and in the co-presence of an organic protective agent.

The alcohol or polyol used in the present invention as an organic solvent/reducing agent is required to have a boiling point of 85 °C or greater but is not otherwise particularly limited. An alcohol having a boiling point below 85 °C does not readily enable a reaction temperature of 85 °C or higher without using a special reactor such as an autoclave. Complete reduction of silver carbonate or silver oxide to silver is difficult to achieve at a reaction temperature below 85 °C. Preferred examples of the organic solvent/reducing agent are isobutanol and n-butanol, either individually or in a mixture of the two, but this is not a restriction and any organic solvent/reducing agent having a boiling point of 85 °C or greater can be used. As the compound other than silver nitrate, a silver compound that is sparingly soluble in the organic solvent, such as silver carbonate, silver oxide or the like is used. Silver nitrate is undesirable because the starting material thereof readily entrains $I^-$, $Cl^-$, $SO_4^{2-}$, $NO_3^-$, $CN^-$ and other such ions. Silver carbonate, silver oxide and the like are used in the form of powder.

As the organic protective agent, there is used a metal coordination compound of a molecular weight of 100 to 400 that has coordinating capability toward silver, typically a fatty acid or amino compound. When a compound having no or only weak coordinating capability toward silver is used, a large amount of the protective agent is required to produce nanoparticles. Viewed generally, metal coordination compounds include isonitrile compounds, sulfur compounds, amino compounds, and fatty acids having a carboxyl group. However, a sulfur compound would degrade the reliability of electronic components because it would cause corrosion owing to the sulfur it contains. Isonitrile compounds have problems of toxicity and the like. This invention enables provision of a material for forming interconnects free of these problems by using a fatty acid or amino compound having a molecular weight of 100 to 400 as the organic protective agent.

The amino compound is preferably a primary amine. A secondary amine or tertiary amine would itself operate as a reducing agent, which would cause an inconvenience in a case where an alcohol is already in use as a reducing agent, because the resulting presence of two types of reducing agent would complicate control of the reduction rate and the like. An amino compound or fatty acid having a molecular weight of less than 100 has low agglomeration suppressing effect. One with a molecular weight exceeding 400 has strong agglomeration suppressing effect but also has a high boiling point. If a particulate silver powder whose particle surfaces are coated therewith should be used as a material for forming interconnects, the amino compound or fatty acid would act as a sinter inhibitor during firing. The resistance of the interconnects would therefore become high, possibly to the point of impairing conductivity. Since this is undesirable, it is best to use an amino compound or fatty acid having a molecular weight of 100 - 400.

The reduction of the silver carbonate or silver oxide in alcohol or polyol is best conducted using an apparatus equipped with a reflux condenser to return vaporized alcohol or polyol to the liquid phase during the reaction. The silver concentration of the reaction mixture is preferably made 50 mmole/L or greater. A lower concentration than this is not suitable because cost increases.

Upon completion of the reaction, the slurry obtained is centrifuged to separate solid from liquid. The resulting sediment is added with a dispersion medium such as ethanol and dispersed therein using an ultrasonic disperser. The dispersion is again centrifuged and the sediment is again added with ethanol and dispersed with the ultrasonic disperser. This process of [solid-liquid separation → dispersion] is repeated three times, whereafter the supernatant is discarded and the sediment dried to obtain the particulate silver powder of the present invention.

The particulate silver powder obtained is dried in a vacuum drier (for 12 hours at 200 °C, for example), whereafter the dry product can be assayed for silver purity using the gravimetric method (upon dissolution in nitric acid followed by addition of HCl to prepare a silver chloride precipitate) to measure purity from the weight thereof. The purity of the particulate silver powder of the present invention is 90% or greater. Moreover, as pointed out earlier, the particulate silver powder has a content of each of $I^-$, $Cl^-$, $SO_4^{2-}$, $NO_3^-$ and $CN^-$ of 100 ppm or less. As the dispersion medium for dispersing the invention particulate silver powder can be used an ordinary non-polar solvent or a low-polarity solvent such as hexane, toluene, kerosene, decane, dodecane or tetradecane. The liquid dispersion obtained is then centrifuged to remove coarse particles and agglomerated particles. Next, only the supernatant is collected as a sample to be subjected to TEM, x-ray, particle size distribution and other measurements.

Working Examples

Example 1

Isobutanol (reagent grade from of Wako Pure Chemical Industries, Ltd.), 200 mL, used as a solvent/reducing agent, was added with 0.1329 mL of oleic acid (Wako Pure Chemical Industries, Ltd.) and 5.571 g of silver carbonate powder (Kojundo Chemical Laboratory Co., Ltd.), and the mixture was stirred lightly with a spoon. The solution was transferred to a container equipped with a reflux condenser which was then placed in an oil bath. The solution was stirred with a magnetic stirrer at 200 rpm and heated while nitrogen gas used as an inert gas was blown into the container at the rate of 400 mL/min. Refluxing was continued for 3 hours at 100°C to complete the reaction. The temperature increase rate to 100 °C was 1 °C/min.

After the reaction, the slurry was subjected to solid-liquid separation and washing by the procedure set out below:

1. The slurry following the reaction was centrifuged at 5000 rpm for 60 minutes in a CF7D2 centrifuge made by Hitachi Koki Co., Ltd. to separate solid from liquid, and the supernatant was discarded.
2. The sediment was added with ethanol and dispersed using an ultrasonic disperser.
3. Steps 1 and 2 were repeated 3 times.
4. Step 1 was performed and the supernatant was discarded to obtain a sediment.

The pasty sediment obtained in Step 4 was prepared for evaluation as follows:

a) For the measurement of particle size distribution by TEM observation and dynamic light-scattering, the sediment was added with and dispersed in kerosene, the liquid dispersion was centrifuged to sediment coarse particles, and the supernatant was recovered to obtain a dispersion of independent fine particles of silver.
b) For the x-ray diffraction and crystallite size measurement, the independent liquid dispersion was concentrated to a paste that was coated onto a non-reflective substrate and analyzed with an x- ray diffractometer.
c) For determining Ag purity and yield, the sediment obtained in 4 was dried in a vacuum drier for 12 hours at 200°C and the weight of the dried product was measured. More specifically, the Ag purity of the dried product was measured by the gravimetric method (method of dissolving the dried product in nitric acid, adding HCl to the solution to prepare a silver chloride precipitate, and measuring the purity from the weight thereof). Yield was calculated as (weight of dried product / theoretical yield calculated from materials used to prepare the reaction solution) x 100 (%).

d) For measuring the content of the corrosive components $I^-$, $Cl^-$, $SO_4^{2-}$, $NO_3^-$ and $CN^-$, analysis was performed on the sediment obtained in 4 after it had been dried in a vacuum drier at room temperature for 12 hours.

The results of the measurements were TEM average particle diameter: 7.7 nm, aspect ratio: 1.2, X-ray crystallite size (Dx): 8.12 nm, and degree of single crystal grain (DTEM / Dx): 0.95. Only peaks attributable to silver were observed in the x-ray diffraction results. D50 measured by the dynamic light-scattering method (Microtrack UPA) was 20.2 nm. D50 / DTEM was 2.6. Silver purity was 93% and silver yield was 93.1%. The content of each of $I^-$, $Cl^-$, $SO_4^{2-}$, $NO_3^-$ and $CN^-$ was 100 ppm or less in both the dried silver nanoparticles and the liquid dispersion.

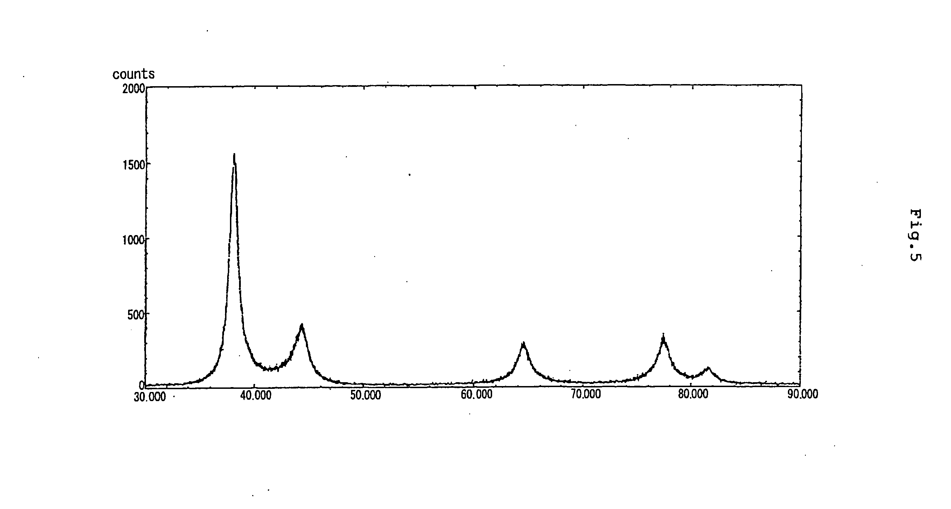

FIGs. 1 and 2 are TEM photographs of the nanoparticle silver powder of this Example (photographs for determining TEM average particle diameter and the like). In these photographs, spherical silver nanoparticles are observed to be well dispersed at regular intervals. Although a very small number of overlapped particles are observed, the measurements of average particle diameter (DTEM), aspect ratio and CV value were made with respect to completely dispersed particles. FIG 5 is an x-ray diffraction chart of a nanoparticle silver powder of this Example. As can seen in FIG. 5, only peaks attributable to silver are observed.

Example 2

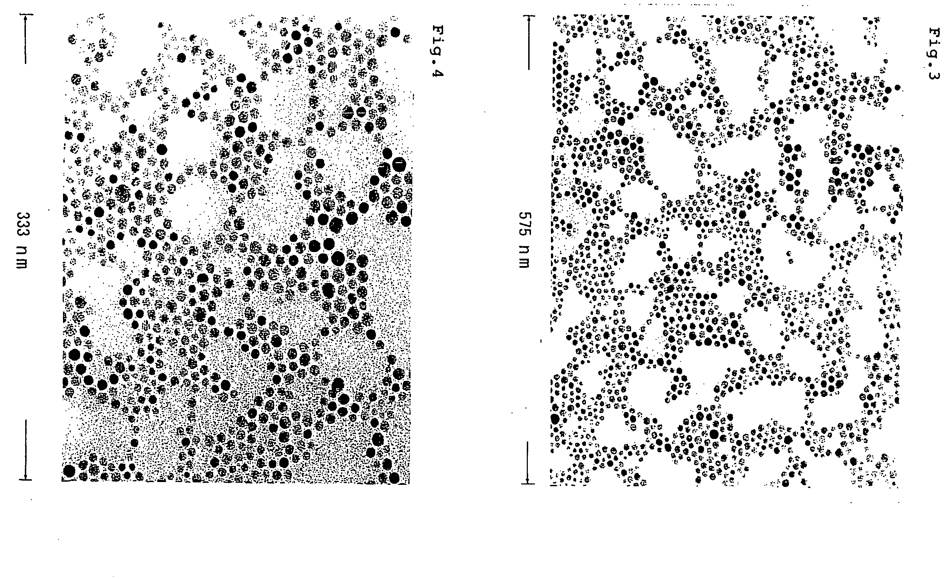

Example 1 was repeated except that 5.571 g of silver carbonate powder was changed to 4.682 g of silver oxide powder (Dowa Mining Co., Ltd.) The results of the measurements were TEM average particle diameter: 6.0 nm, aspect ratio: 1.15, X-ray crystallite size (Dx): 6.52 nm, and degree of single crystal grain (DTEM / Dx): 0.92. D50 measured by the dynamic light-scattering method (Microtrack UPA) was 21.2 nm. D50 / DTEM was 3.53. Silver purity was 92% and silver yield was 90.1%. TEM photographs of the nanoparticle silver powder are shown in FIGs. 3 and 4. Also for the nanoparticle silver powder of this Example, only peaks attributable to silver were observed in the x-ray diffraction results. The content of each of $I^-$, $Cl^-$, $SO_4^{2-}$, $NO_3^-$ and $CN^-$ was 100 ppm or less in both the dried silver nanoparticles and the liquid dispersion.

Comparative Example 1

An attempt was made to repeat Example 1 with the silver carbonate powder, 5.571 g, changed to silver nitrate crystal, 6.863 g. The silver nitrate was dissolved in the oleic acid and added to the isobutanol. Although the result was continuously stirred, it did not dissolve. The sediment obtained following heating and reaction in this condition was subjected to x-ray measurement but almost no peaks attributable to silver were observed. Silver oleate was probably produced.

Claims

1.   A method of manufacturing a particulate silver powder which comprises:

subjecting a silver compound selected from silver carbonate or silver oxide to reduction in an organic solvent selected from an alcohol or a polyol that functions as a reducing agent and has a boiling point of 85 °C or greater at a temperature of 85 °C or greater and in the presence of an organic protective agent selected from a fatty acid or amino compound having a molecular weight of 100 to 400, thereby adhering the fatty acid or amino compound to the surfaces of particulate silver powder particles formed, which powder has an average particle diameter measured by TEM observation (DTEM) of 200 nm or less, an aspect ratio of less than 2.50, and a {(DTEM)/(Dx)} of 5.0 or less, where (Dx) denotes X-ray crystallite size, and has a content of each of $I^-$, $Cl^-$, $SO_4^{2-}$, $NO_3^-$ and $CN^-$ of 100 ppm or less.

2.   A method of manufacturing a liquid dispersion of silver particles which comprises:

manufacturing a particulate silver powder in accordance with the method of claim 1, and subsequently dispersing the silver particles thus obtained in a non-polar or low-polarity organic solvent having a boiling point of 80 °C or greater.

Patentansprüche

1.   Ein Verfahren zur Herstellung eines partikelförmigen Silberpulvers, das folgendes aufweist:

Aussetzen einer Silberverbindung, ausgewählt aus Silberkarbonat oder Silberoxyd gegenüber einer Reduktion in einem organischen Lösungsmittel ausgewählt aus einem Alkohol oder Polyol, das als eine reduzierende Agens wirkt und einen Siedepunkt von 85°C oder höher besitzt, und zwar bei einer Temperatur von 85°C oder höher und in der Gegenwart einer organischen Schutzagens, ausgewählt aus einer Fettsäure oder einer Aminoverbindung mit einem Molekulargewicht von 100 - 400, um **dadurch** ein Anhaften der Fettsäure oder der Aminoverbindung an den Oberflächen von partikelförmigen Silberpulverpartikeln, die gebildet werden zu bewirken, wobei das Pulver einen durchschnittlichen Partikeldurchmesser gemessen durch TEM-Observation (DTEM) von 200nm oder kleiner besitzt, ein Aspektverhältnis von weniger als 2,50, und ein {(DTEM)/(Dx)} von 5,0 oder kleiner, wobei (Dx) eine Röntgenkristallitgröße bezeichnet, und wobei das Pulver jeweils einen Gehalt von $I^-$, $Cl^-$, $SO_4^{2-}$, $NO_3^-$ und CN- von 100 ppm oder weniger aufweist.

2. Verfahren zur Herstellung einer flüssigen Dispersion aus Silberpartikeln, wobei das Verfahren das Herstellen eines partikelförmigen Silberpulvers gemäß dem Verfahren nach Anspruch 1 und das nachfolgende Dispergieren der so erhaltenen Silberpartikel in einem nicht-polaren oder eine geringe Polarität aufweisenden organischen Lösungsmittel mit einem Siedepunkt von 80°C oder größer aufweist.

disperser ensuite les particules d'argent ainsi obtenues dans un solvant organique non polaire ou à faible polarité ayant un point d'ébullition de 80°C ou plus.

**Revendications**

1. Procédé de fabrication d'une poudre de particules d'argent, comprenant les étapes suivantes :

soumettre un composé d'argent choisi parmi le carbonate d'argent et l'oxyde d'argent à une réduction dans un solvant organique choisi parmi un alcool et un polyol qui agit en tant qu'agent réducteur et a un point d'ébullition de 85°C ou plus à une température de 85°C ou plus, et en présence d'un agent protecteur organique choisi parmi un acide gras et un composé aminé ayant un poids moléculaire de 100 à 400, faisant ainsi adhérer l'acide gras ou le composé aminé aux surfaces des particules de poudre d'argent formées, la poudre ayant un diamètre moyen de particule mesuré par observation TEM (DTEM) de 200 nm ou moins, un facteur de forme inférieur à 2,50, et un rapport {(DTEM)/(Dx)} de 5,0 ou moins, (Dx) représentant une taille de cristallite déterminée par rayons X, et ayant un contenu en $I^-$, $Cl^-$, $SO_4^{2-}$, $NO_3^-$ et CN- de 100 ppm ou moins.

2. Procédé de fabrication d'une dispersion liquide de particules d'argent comprenant les étapes suivantes :

fabriquer une poudre de particules d'argent conformément au procédé de la revendication 1, et

Fig.1

|————          575 nm          ————|

Fig.2

|————          333 nm          ————|

Fig.3

|←――――――                           575 n m                           ――――→|

Fig.4

|←――――――                           333 n m                           ――――→|

Fig.5

## REFERENCES CITED IN THE DESCRIPTION

**Patent documents cited in the description**

- JP 2001035255 A
- JP 11319538 A
- JP 2003253311 A
- US 200218896 A1
- JP 2004183009 A

**Non-patent literature cited in the description**

- CHEMISTRY LETTERS. CHEMICAL SOCIETY OF JAPAN, 2004, vol. 33, 158-159